# EUROPEAN PATENT APPLICATION

(11) **EP 3 200 195 A1**
(43) Date of publication of application: **02.08.2017**
(21) Application number: 15845048.6
(22) Date of filing: 07.09.2015
(51) Int. Cl.: H01B 5/14, G09F 9/00, H01L 51/50

(54) **FLEXIBLE SUBSTRATE AND METHOD OF MANUFACTURING SAME**

(30) Priority: 23.09.2014 KR 20140126852
(71) Applicant: Corning Precision Materials Co., Ltd., Asan-si, Chungcheongnam-do 336-841 (KR)
(72) Inventor: CHUNG, Jin Wook, Asan-si Chungcheongnam-do 336-841 (KR); KIM, Min Seok, Asan-si Chungcheongnam-do 336-841 (KR); YOON, Hong, Asan-si Chungcheongnam-do 336-841 (KR)
(74) Representative: Gulde & Partner
(86) International application number: PCT/KR2015/009400
(87) International publication number: WO 2016/047936

(57) **Abstract**

The present invention relates to a flexible substrate and a method of manufacturing same and, more particularly, to a flexible substrate and a method of manufacturing same, the flexible substrate having high flexibility, high transparency, and high conductivity, so as to be able to improve the quality of a flexible display device to which it is applied. To this end, the present invention provides a flexible substrate and a method of manufacturing same, the flexible substrate characterized by comprising: a flexible base material; an ITO thin film formed on the flexible base material; and a plurality of nano particles discontinuously distributed within the ITO thin film.

## Description

### TECHNICAL FIELD

The present disclosure relates to a flexible substrate and a method of manufacturing the same. More particularly, the present disclosure relates to a flexible substrate having high levels of flexibility, transparency, and conductivity to improve the quality of a flexible display device provided with the flexible substrate and a method of manufacturing the flexible substrate.

### BACKGROUND ART

The display device market has experienced a rapid change in product trends, away from cathode ray tube (CRT) display devices towards flat panel displays (FPDs). Representative examples of FPDs are liquid crystal displays (LCDs), plasma display panels (PDPs), organic light-emitting diode (OLED) display devices, and the like, all of which are lighter, thinner, and easier to manufacture in larger sizes, as compared to CRT display devices.

Recently, advances in display technology are moving away from existing flat displays toward flexible displays, requiring higher mechanical flexibility. Future display devices are expected to have evolved into bendable, rollable, foldable, and stretchable structures. To realize flexible displays, all components of displays are required to be flexible. In particular, the improvement of the mechanical flexibility of transparent electrodes is most significant.

Transparent electrode materials are typically thin films having visible light transmittance of 80% or higher and sheet resistance of less than 1000 Ω/sq. A representative transparent electrode material that is currently most commonly used is indium tin oxide (ITO), comprised of 90% In₂O₃ and 10% SnO₂.

ITO is suitably applicable to flat panel displays (FPDs), due to characteristics thereof, such as superior electrical conductivity, superior light transmittance, and ease of processing. However, the poor mechanical flexibility of ITO may cause problems when ITO is used in flexible displays. For example, at a radius of curvature (or bending) of 10 mm or less, cracks may be formed and electrical conductivity may be reduced.

In the related art, ITO was replaced by substitute transparent electrode materials, such as a metal mesh grid and Ag nanowires, to improve the flexibility of transparent electrodes. However, the application of substitute transparent electrode materials is not easy, due to complicated processes and compatibility with existing display processes. Therefore, a solution for using ITO transparent electrodes by improving the mechanical flexibility thereof is in demand.

### [Related Art Document]

Korean Patent Application Publication No. 10-2011-0135612 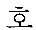 (December 19, 2011)

### DISCLOSURE

### Technical Problem

Accordingly, the present disclosure has been made in consideration of the above problems occurring in the related art, and the present disclosure proposes a flexible substrate having high levels of flexibility, transparency, and conductivity to improve the quality of a flexible display device provided with the flexible substrate and a method of manufacturing the flexible substrate.

### Technical Solution

According to an aspect of the present disclosure, a flexible substrate may include: a flexible base; an indium tin oxide thin film disposed on the flexible base; and a number of nanoparticles discontinuously distributed in the indium tin oxide thin film.

The indium tin oxide thin film may contain Al-doped ZnO and In-doped ZnO therein.

The number of nanoparticles may be formed from a metal oxide selected from the group consisting of SiO₂, TiO₂, and Al₂O₃.

Surfaces of the nanoparticles may be exposed from a surface of the indium tin oxide thin film to be flush with the surface of the indium tin oxide thin film.

The flexible base may be formed from one selected from the group consisting of a thin glass sheet, a metal thin film, polyethylene terephthalate, polycarbonate, and polyimide.

The flexible base may be used as a cover substrate of an organic light-emitting diode device, and the indium tin oxide thin film may be used as a transparent electrode acting as an anode of the organic light-emitting diode device.

The flexible substrate may further include a barrier layer disposed between the indium tin oxide thin film and an organic light-emitting layer of the organic light-emitting diode device.

According to another aspect of the present disclosure, provided is a method of manufacturing a flexible substrate. The method may include: forming a number of nanoparticles discontinuously on a flexible base; depositing an indium tin oxide thin film on the flexible base on which the number of nanoparticles are disposed; and planarizing a surface of the indium tin oxide thin film deposited on the flexible base.

Forming the number of nanoparticles may include: providing the number of nanoparticles on the flexible base by spin coating; and post-processing the number of nanoparticles using heat or plasma after the spin coating.

Depositing the indium tin oxide on the flexible base may include: depositing the indium tin oxide thin film on the flexible base by sputtering or spin coating; and post-processing the deposited indium tin oxide thin film using heat or plasma.

The surface of the indium tin oxide thin film deposited on the flexible base may be planarized such that surfaces of the number of nanoparticles are exposed externally.

The number of nanoparticles may be formed from a metal oxide selected from the group consisting of SiO₂, TiO₂, and Al₂O₃.

### Advantageous Effects

According to the present disclosure, a number of nanoparticles having superior transparency and flexibility is discontinuously provided within a transparent thin film disposed on a base, thereby imparting a flexible substrate with high levels of flexibility, transparency, and conductivity.

In addition, according to the present disclosure, when the transparent thin film having the number of nanoparticles distributed therein is used as a transparent electrode acting as an anode of an OLED device, the transparent thin film can also act as an internal light extraction layer. Then, an internal light extraction layer that would otherwise be provided in a conventional OLED device as a separate layer from a transparent electrode can be omitted, thereby reducing the thickness of the OLED device. In addition, the reduced number of layers can simplify the manufacturing process.

Furthermore, according to the present disclosure, the flexible substrate can not only be used in the OLED device, but also in other flexible devices, such as a touch panel, electronic paper, a photovoltaic device, a light-emitting diode (LED), a quantum dot (QD) display device, and a lighting device, in which a transparent electrode is used. The flexible substrate can improve the quality of these flexible devices when used therein.

### DESCRIPTION OF DRAWINGS

FIG. 1 is a cross-sectional view illustrating a flexible substrate according to an exemplary embodiment;
FIG. 2 is a cross-sectional view illustrating an OLED device including the flexible substrate according to the exemplary embodiment;
FIGS. 3 to 5 are process views illustrating a method of manufacturing a flexible substrate according to the exemplary embodiment, in the sequence of processes; and
FIGS. 6 and 7 are process views illustrating a process of manufacturing an OLED on a flexible substrate manufactured by the method of manufacturing a flexible substrate according to the exemplary embodiment.

### MODE FOR INVENTION

Hereinafter, a flexible substrate and a method of manufacturing the same according to exemplary embodiments will be described in detail with reference to the accompanying drawings.

In the following description, detailed descriptions of known functions and components incorporated herein will be omitted in the case that the subject matter of the present disclosure may be rendered unclear by the inclusion thereof.

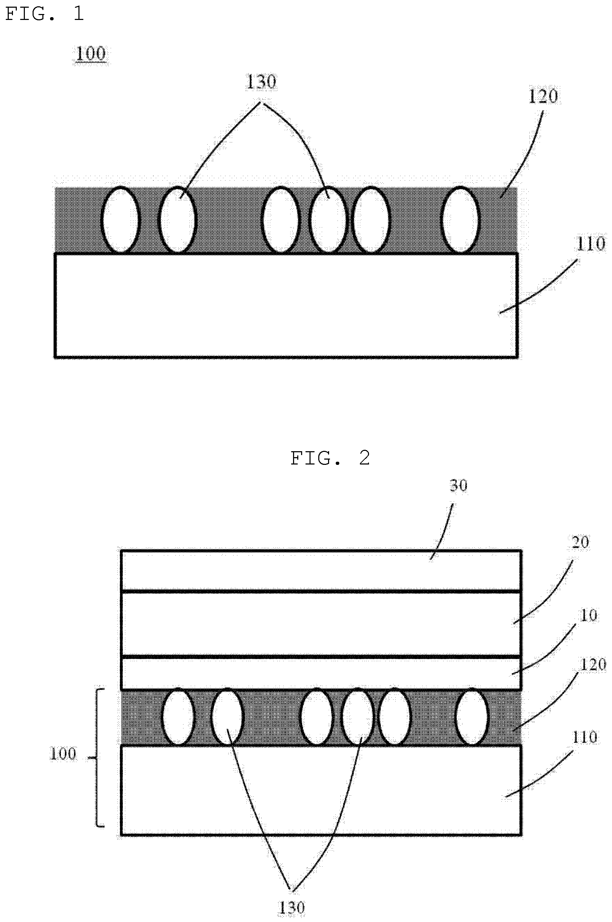

As illustrated in FIG. 1, a flexible substrate 100 according to an exemplary embodiment is a substrate that can be used as a cover substrate of a flexible organic light-emitting diode (OLED) device for lighting. The flexible substrate 100 includes a flexible base 110, an indium tin oxide (ITO) thin film 120, and a number of nanoparticles 130.

The flexible base 110 is a substrate supporting the ITO thin film 120 and the number of nanoparticles 130. When the flexible substrate 100 is used as a cover substrate of an OLED device, the flexible substrate 110 is disposed in a portion of the OLED device, i.e. on a surface of an OLED, through which light generated thereby exits, to allow light to pass therethrough, while serving as an encapsulation substrate to protect the ITO thin film 120, the number of nanoparticles 130, and the OLED from the external environment.

The flexible base 110 may be formed from a material having flexibility, such as a thin glass sheet, a metal thin film, polyethylene terephthalate (PET), polycarbonate (PC), and polyimide (PI). However, the flexible base 110 according to the exemplary embodiment is not limited to the above-stated materials, since the flexible base 110 may be formed from a range of other materials having flexibility.

The ITO thin film 120 is disposed on the flexible base 110. The number of nanoparticles 130 are distributed within the ITO thin film 120, thereby imparting the ITO thin film 120 with flexibility. The surfaces of the nanoparticles 130 are exposed from the surface of the ITO thin film 120. The exposed surfaces of the nanoparticles 130 are flush with the surface of the ITO thin film 120. The ITO thin film 120 may contain Al-doped ZnO (AZO) and In-doped ZnO (IZO).

As illustrated in FIG. 2, the ITO thin film 120 according to the exemplary embodiment is used as a transparent electrode acting as an anode of the OLED device. The ITO thin film 120 also acts as an internal light extraction layer of the OLED device. When the ITO thin film 120 acts as not only the transparent electrode of the OLED device but also as the internal light extraction layer of the OLED device, an internal light extraction layer that would otherwise be provided in a conventional OLED device as a separate layer from a transparent electrode can be omitted, thereby reducing the thickness of the OLED device. For example, in the convention OLED device, the internal light extraction layer having a thickness of 1 µm to 2 µm and the ITO transparent electrode having a thickness of 150 nm are provided as separate layers. In contrast, the ITO thin film 120 having the number of nanoparticles 130 distributed therein according to the exemplary embodiment is provided at a thickness of 100 nm to 600 nm to act as both the transparent electrode and the internal light extraction layer of the OLED device.

As illustrated in FIG. 2, the OLED has a multilayer structure sandwiched between the flexible base 110 and another base (not shown) encapsulation facing the flexible base 110 to encapsulate the multilayer structure of the OLED. The multilayer structure of the OLED is comprised of a transparent electrode, an organic light-emitting layer 20, and a rear electrode 30. The ITO thin film 120 according to the exemplary embodiment is used as a transparent electrode acting as the anode of the OLED device. The rear electrode 30 is a metal electrode acting as a cathode of the OLED device. The rear electrode 30 may be a metal thin film formed from a metal having a smaller work function, such as Al, Ni, Ag, or Cu, or a composite layer formed from a combination thereof, to facilitate electron injection. The rear electrode 30 must have a small thickness of several tens of nanometers to several hundreds of nanometers to be flexible. The organic light-emitting layer 20 is comprised of a hole injection layer, a hole transport layer, an emission layer, an electron transport layer, and an electron injection layer that are sequentially stacked on the ITO thin film 120 acting as the transparent electrode.

According to this structure, when a forward voltage is induced between the ITO thin film 120 and the rear electrode 30, electrons migrate from the rear electrode 30 to the emission layer through the electron injection layer and the electron transport layer, while holes migrate from the ITO thin film 120 to the emission layer through the hole injection layer and the hole transport layer. The electrons and the holes that have migrated into the emission layer recombine with each other, thereby generating excitons. These excitons transit from an excited state to a ground state, thereby emitting light. The brightness of the emitted light is proportional to the amount of current that flows between the ITO thin film 120 and the rear electrode 30.

When the OLED is a white OLED used for lighting, the light-emitting layer may have a multilayer structure comprised of a high-molecular light-emitting layer emitting blue light and a low-molecular light-emitting layer emitting orange-red light, or may have a variety of other structures that emit white light.

The organic light-emitting layer 20 may also have a tandem structure. In this case, a plurality of organic light-emitting layers 20 alternating with interconnecting layers may be provided.

A barrier layer 10 formed from a high-conductivity and high-transparency material is further provided between the ITO thin film 120 and the organic light-emitting layer 20. The barrier layer 10 serves to prevent indium (In) from diffusing from the ITO thin film 120 into the organic light-emitting layer 20.

The number of nanoparticles 130 are discontinuously distributed within the ITO thin film 120. The surfaces of the number of nanoparticles 130 are exposed from the surface of the ITO thin film 120 while being flush with the surface of the ITO thin film 120.

In general, porous materials are relatively more flexible and elastic than the other materials. According to the exemplary embodiment, the number of nanoparticles 130 are discontinuously distributed in a structure similar to porous materials, thereby imparting flexibility to the ITO thin film 120 having poor mechanical flexibility. The number of nanoparticles 130 may be formed from a metal oxide selected from among candidate metal oxides having superior transparency and flexibility, such as SiO₂, TiO₂, and Al₂O₃. When the number of nanoparticles 130 are formed from any one of the candidate metal oxides, the transparency of the ITO thin film 120 can be improved to be higher than that of the conventional ITO transparent electrode. However, the electrical conductivity of the ITO thin film 120 used as the transparent electrode of the OLED may be decreased, since the metal oxide is a nonconducting material. Thus, the type and amount of the number of nanoparticles 130 contained in the ITO thin film 120 may be controlled according to the specification of a display devices or a lighting device in which the OLED is used, such that the ITO thin film 120 exhibits maximal levels of conductivity, flexibility, and transparency.

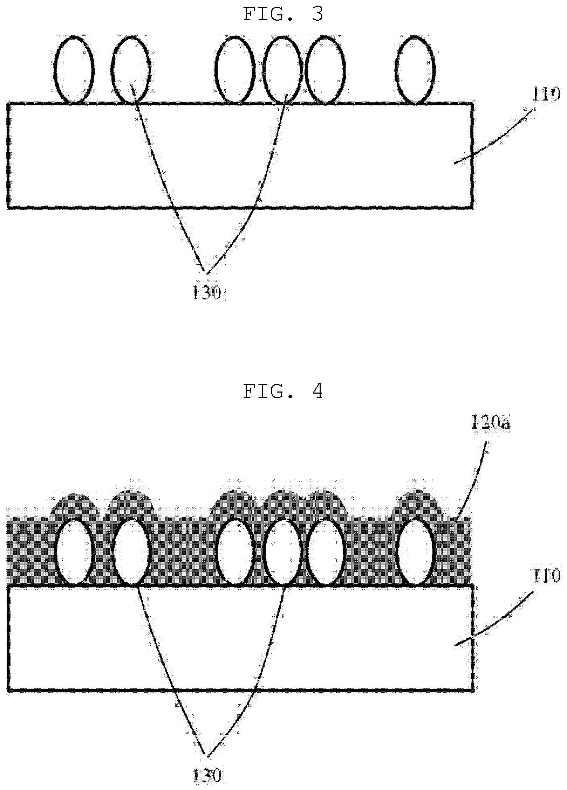

Hereinafter, a method of manufacturing the flexible substrate according to the exemplary embodiment will be described with reference to FIGS. 3 to 7.

The method of manufacturing the flexible substrate according to the exemplary embodiment includes a nanoparticle forming step, an ITO deposition step, and a planarization step.

First, as illustrated in FIG. 3, the nanoparticle forming step is a step of providing a number of nanoparticles 130 to be discontinuously distributed on a flexible base 110. In the nanoparticle forming step, the number of nanoparticles 130 formed from a metal oxide, such as SiO₂, TiO₂, or Al₂O₃, are provided on the flexible base 110 by spin coating. The number of nanoparticles 130 have sizes of several hundreds of nanometers. In the nanoparticle forming step, after the spin coating, the number of nanoparticles 130 are post-processed using heat or plasma to rearrange the number of nanoparticles 130 to be discontinuously distributed and improve the characteristics of the number of nanoparticles 130.

In the nanoparticle forming step, the flexible base 110 may be formed from one selected from among a thin glass sheet, a metal thin film, polyethylene terephthalate (PET), polycarbonate (PC), and polyimide (PI).

As illustrated in FIG. 4, the subsequent ITO deposition step is a step of depositing indium tin oxide (ITO) on the flexible base 110 on which the number of nanoparticles 130 are disposed, thereby forming an ITO thin film 120a. In the ITO deposition step, the ITO thin film 120a is deposited on the flexible base 110 by sputtering or spin coating. Afterwards, the deposited ITO thin film 120a is post-processed using heat or plasma to improve the characteristics of the ITO thin film 120a. In the ITO deposition step, the ITO thin film 120a may contain Al-doped ZnO (AZO) and In-doped ZnO (IZO).

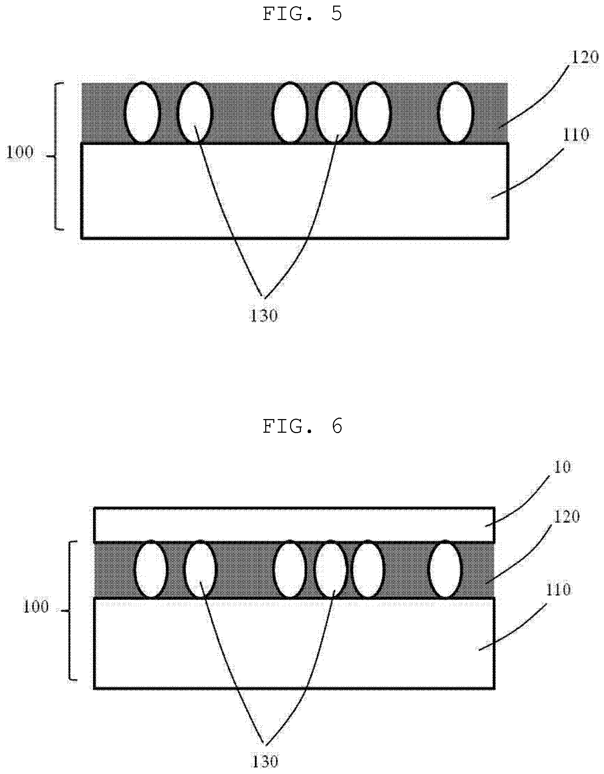

As illustrated in FIG. 5, the subsequent planarization step is a step of planarizing the surface of the ITO thin film 120a formed in the ITO deposition step. In the planarization step, the surface of the ITO thin film 120 is planarized such that the surfaces of the number of nanoparticles 130 are exposed externally. To form the surface of the ITO thin film 120 as a high flat surface, the planarization operation must be performed to such an extent that the surfaces of the number of nanoparticles 130 are exposed externally.

When the planarization step is completed as described above, a flexible substrate 100 according to an exemplary embodiment is manufactured. The flexible substrate 100 manufactured as described above has high levels of flexibility and transparency, since the number of nanoparticles 130 having superior transparency and flexibility are discontinuously distributed within the ITO thin film 120.

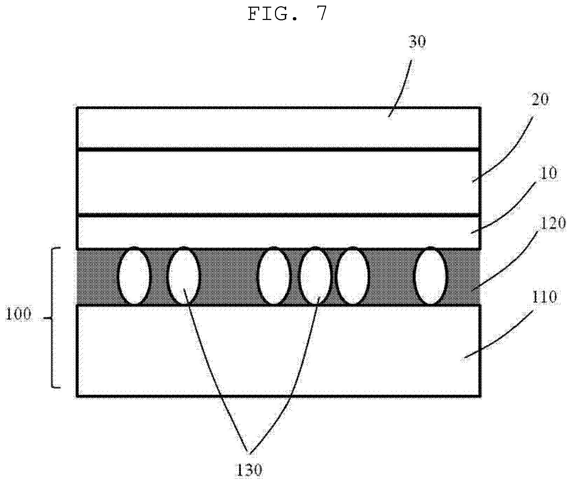

The flexible substrate 100 can be used as a cover substrate of an OLED device. As illustrated in FIG. 6, a barrier layer 10 formed from a material having high conductivity and transparency is provided on the ITO thin film 120. However, the operation of forming the barrier layer 10 can be omitted. Afterwards, as illustrated in FIG. 7, an organic light-emitting layer 20 and a rear electrode 30 are sequentially stacked on the flexible substrate, thereby completing the manufacturing of the flexible OLED device.

The ITO thin film 120 having the number of nanoparticles 130 distributed therein is used not only as a transparent electrode acting as an anode of the OLED device but also acts as an internal light extraction layer of the OLED device. Then, an internal light extraction layer that would otherwise be provided in a conventional OLED device as a layer separate from a transparent electrode can be omitted, thereby reducing the thickness of the OLED device. In addition, the reduced number of layers can simplify the manufacturing process.

Although the flexible substrate 100 according to the exemplary embodiment has been described as being used as a cover substrate of an OLED device, the flexible substrate 100 can not only be used in the OLED device, but also in other flexible devices, such as a touch panel, electronic paper, a photovoltaic device, a light-emitting diode (LED), a quantum dot (QD) display device, and a lighting device, in which a transparent electrode is used.

The flexible substrate 100 can improve the quality of these flexible devices when used therein.

The foregoing descriptions of specific exemplary embodiments of the present disclosure have been presented with respect to the drawings. They are not intended to be exhaustive or to limit the present disclosure to the precise forms disclosed, and obviously many modifications and variations are possible for a person having ordinary skill in the art in light of the above teachings.

It is intended therefore that the scope of the present disclosure not be limited to the foregoing embodiments, but be defined by the Claims appended hereto and their equivalents.

## Claims

1. A flexible substrate comprising:
a flexible base;
an indium tin oxide thin film disposed on the flexible base; and
a number of nanoparticles discontinuously distributed in the indium tin oxide thin film.

2. The flexible substrate of claim 1, wherein the indium tin oxide thin film contains Al-doped ZnO and In-doped ZnO therein.

3. The flexible substrate of claim 1, wherein the number of nanoparticles is formed from a metal oxide selected from the group consisting of SiO₂, TiO₂, and Al₂O₃.

4. The flexible substrate of claim 1, wherein surfaces of the nanoparticles are exposed from a surface of the indium tin oxide thin film to be flush with the surface of the indium tin oxide thin film.

5. The flexible substrate of claim 1, wherein the flexible base is formed from one selected from the group consisting of a thin glass sheet, a metal thin film, polyethylene terephthalate, polycarbonate, and polyimide.

6. The flexible substrate of claim 1, wherein the flexible base comprises a cover substrate of an organic light-emitting diode device, and the indium tin oxide thin film comprises a transparent electrode acting as an anode of the organic light-emitting diode device.

7. The flexible substrate of claim 6, further comprising a barrier layer disposed between the indium tin oxide thin film and an organic light-emitting layer of the organic light-emitting diode device.

8. A method of manufacturing a flexible substrate, comprising:
forming a number of nanoparticles discontinuously on a flexible base;
depositing an indium tin oxide thin film on the flexible base on which the number of nanoparticles are disposed; and
planarizing a surface of the indium tin oxide thin film deposited on the flexible base.

9. The method of claim 8, wherein forming the number of nanoparticles comprises:
providing the number of nanoparticles on the flexible base by spin coating; and
post-processing the number of nanoparticles using heat or plasma after the spin coating.

10. The method of claim 8, wherein depositing the indium tin oxide on the flexible base comprises:
depositing the indium tin oxide thin film on the flexible base by sputtering or spin coating; and
post-processing the deposited indium tin oxide thin film using heat or plasma.

11. The method of claim 8, wherein the surface of the indium tin oxide thin film deposited on the flexible base is planarized such that surfaces of the number of nanoparticles are exposed externally.

12. The method of claim 8, wherein, the number of nanoparticles are formed from a metal oxide selected from the group consisting of SiO₂, TiO₂, and Al₂O₃.

## Amended claims

### Amended claims under Art. 19.1 PCT

1. (Amended) A flexible substrate comprising:
a flexible base;
an indium tin oxide thin film disposed on the flexible base; and
a number of nanoparticles discontinuously distributed in the indium tin oxide thin film,
wherein surfaces of the nanoparticles are exposed from a surface of the indium tin oxide thin film to be flush with the surface of the indium tin oxide thin film.

2. The flexible substrate of claim 1, wherein the indium tin oxide thin film contains Al-doped ZnO and In-doped ZnO therein.

3. The flexible substrate of claim 1, wherein the number of nanoparticles is formed from a metal oxide selected from the group consisting of SiO₂, TiO₂, and Al₂O₃.

4. (Deleted)

5. The flexible substrate of claim 1, wherein the flexible base is formed from one selected from the group consisting of a thin glass sheet, a metal thin film, polyethylene terephthalate, polycarbonate, and polyimide.

6. The flexible substrate of claim 1, wherein the flexible base comprises a cover substrate of an organic light-emitting diode device, and the indium tin oxide thin film comprises a transparent electrode acting as an anode of the organic light-emitting diode device.

7. The flexible substrate of claim 6, further comprising a barrier layer disposed between the indium tin oxide thin film and an organic light-emitting layer of the organic light-emitting diode device.

8. (Amended) A method of manufacturing a flexible substrate, comprising:
forming a number of nanoparticles discontinuously on a flexible base;
depositing an indium tin oxide thin film on the flexible base on which the number of nanoparticles are disposed; and
planarizing a surface of the indium tin oxide thin film deposited on the flexible base,
wherein the surface of the indium tin oxide thin film deposited on the flexible base is planarized such that surfaces of the number of nanoparticles are exposed externally.

9. The method of claim 8, wherein forming the number of nanoparticles comprises:
providing the number of nanoparticles on the flexible base by spin coating; and
post-processing the number of nanoparticles using heat or plasma after the spin coating.

10. The method of claim 8, wherein depositing the indium tin oxide on the flexible base comprises:
depositing the indium tin oxide thin film on the flexible base by sputtering or spin coating; and
post-processing the deposited indium tin oxide thin film using heat or plasma.

11. (Deleted)

12. The method of claim 8, wherein, the number of nanoparticles are formed from a metal oxide selected from the group consisting of SiO₂, TiO₂, and Al₂O₃.
